# EUROPEAN PATENT APPLICATION

(11) **EP 0 905 521 A2**
(43) Date of publication of application: **31.03.1999**
(21) Application number: 98118178.7
(22) Date of filing: 25.09.1998
(51) Int. Cl.: G01R 1/04, G01R 31/316

(54) **Burn-in testing device**

(30) Priority: 26.09.1997 JP 279707/97
(71) Applicant: MOLEX INCORPORATED, Lisle Illinois 60532 (US)
(72) Inventor: Maeda, Ryu, Yamato-shi, Kanagawa (JP)
(74) Representative: Blumbach, Kramer & Partner GbR

(57) **Abstract**

Disclosed is a novel burn-in socket comprising a carrier- and flexible circuit member assembly. The flexible circuit member has first and second electrically conductive bumps formed on its opposite sides and an electric pattern or circuit formed thereon to make electric connections between the first and second bumps. The first bumps are adapted to abut on the exterior terminals of a semiconductor component such as a semiconductor bare chip or package to be set on the burn-in socket. The second bumps are formed in the flexible circuit member in a position lateral to the first bumps and are so arranged that they may confront the electrically conductive contacts of the carrier in one-to-one correspondence, thereby permitting the second bumps to be put in electrical connection with the electrically conductive contacts of the carrier when the flexible circuit member is laid on the carrier.

## Description

### Background of the Invention

### Field of the Invention

The present invention relates to a burn-in testing device which is used in making a burn-in test on a semiconductor component, and particularly to a small-sized burn-in socket for use in testing semiconductor bare chips and semiconductor packages which have exterior terminals arranged, for example, in the form of ball-grid arrays (BGA) within their chip scale areas (ball-grid arrayed chip scale packages or BGACSPs).

### Background Art

To meet the ever increasing demand for down-sizing, high-speed operation and high-density integration in electronic devices, BGACSPs have been increasingly used. Such a BGACSP has exterior terminals formed in its bottom area, which terminals are balls or gold-plated bumps, and can be mounted onto a printed circuit board along with other electronic parts as a whole. Over time, the terminal-to-terminal interval in such a semiconductor package has been reduced, finally reaching the stage at which the terminal-to-terminal interval cannot be reduced any more in burn-in sockets so far as they use metal spring contacts. Thus, a new structure to overcome such a limit has been sought.

In the fields of liquid crystal displays (LCDs), portable telephone devices, digital video cameras and other small-sized electronic devices, semiconductor bare chips are mounted onto printed circuit boards without modification, in a so-called "multi-chip module" or MCM. To keep pace with these developments, burn-in sockets for semiconductor bare chips or packages have been developed. Such a burn-in socket includes an insulating film having a conductor pattern or circuit and electrically conductive bumps formed thereon. The electrically conductive bumps are connected to the conductor pattern or circuit. Such electrically conductive bumps are formed by plating and are so arranged as to confront the exterior terminals of the semiconductor bare chip. The thus made insulating film is laid on the substrate in correct position, and a semiconductor bare chip is placed on the insulating film with its exterior terminals registering at the electrically conductive bumps of the insulating film, thereby permitting the exterior terminals to be electrically connected to the metal contacts of the bare-in socket via the electrically conductive bumps.

A plurality of burn-in sockets are arranged on a relatively large burn-in board to permit required burn-in tests on the semiconductor packages simultaneously. Therefore, the cost for testing will depend greatly on the number of burn-in sockets to be mounted onto the burn-in board. Thus, there has been a demand for increasing the number of burn-in sockets to be put on a burn-in board. The down-sizing of conventional burn-in sockets designed for BGACSPs has reached the limit; burn-in sockets for semiconductor bare chips are so constructed that the metal contacts of the burn-in sockets are connected to the conductor pads formed on the margins of the insulating films, and accordingly the socket size must be enlarged to permit the making of such electric connections around the insulating films. For this reason the number of burn-in sockets to be mounted onto the burn-in board cannot be increased, and therefore the cost for testing semiconductor packages cannot be reduced.

### Summary of the Invention

One object of the present invention is to provide a burn-in socket structure to meet the demands of down-sizing.

To attain this objective, a burn-in socket according to the present invention uses a flexible circuit member having first electrically conductive bumps formed on its first side to abut the exterior terminals of, for example, the chip scale area (CSA) of a semiconductor bare chip or package, and second electrically conductive bumps formed on its second side, wherein the second electrically conductive bumps are connected to the first electrically conductive bumps via an associated conductor pattern or circuit, and the second electrically conductive bumps are arranged in the flexible circuit member laterally relative to the first electrically conductive bumps and are relative to the electrically conductive contacts of the socket carrier in one-to-one correspondence in position, thereby permitting the second electrically conductive bumps to be electrically connected to the electrically conductive contacts when the flexible circuit member is laid on the carrier.

Preferably, the carrier is a substrate. In a preferred embodiment, the substrate is made of an alumina ceramic sheet. In another preferred embodiment, the substrate is made of a glass epoxy sheet.

Preferably, the flexible circuit member is an insulating film. In a preferred embodiment, the insulating film is made of a polyimide film.

Preferably, the electrically conductive contacts of the carrier are electrically conductive lands.

This arrangement makes it unnecessary to form conductor pads around the insulating film and metal spring contacts in the socket, thus reducing the size of the burn-in socket accordingly. Consequently the number of burn-in sockets to be put on a burn-in board can be significantly increased, and hence the testing cost can be reduced.

Electric connection between the second electrically conductive bumps and the electrically conductive contacts of the carrier may preferably be made by adhering the flexible circuit member onto the carrier by an organic adhesive agent, or preferably by forming metal-to-alloy joinings between the second electrically conductive bumps and the electrically conductive contacts of the carrier.

This has the effect of improving the reliability in required electric connections.

Electric connection between the second electrically conductive bumps of the flexible circuit member and the electrically conductive contacts of the carrier may preferably be made with a resilient pushing force, which is produced by a resilient resin sheet laid on the insulating film when depressed.

This arrangement permits separation of the flexible circuit member from the carrier to allow change for another flexible circuit member. Also, conveniently the flexible circuit member may have a semiconductor package set thereon beforehand and can be placed on a carrier for testing.

Preferably, metal balls or metal pins are joined to one side of the electrically conductive lands which are in circuit with the electrically conductive contacts via electrically conductive through holes.

This permits the adjoining of the carrier of the burn-in socket and the burn-in board via the ball-grid array (BGA) or pin grid array (PGA) of the semiconductor component, contributing the down-sizing of the burn-in socket.

The flexible circuit member may optionally have a resilient resin layer on the side opposite to the side on which the first electrically conductive bumps are formed. Preferably, the resilient resin layer is made of silicone rubber. The burn-in socket further may optionally have a cover plate, preferably comprising a spring member to push a semiconductor package or bare chip against the first electrically conductive bumps.

This arrangement permits the pushing of the exterior terminals of a semiconductor package on the first electrically conductive bumps of the burn-in socket under required good pressure, and irregularities, if any, on either side of the semiconductor package bottom or the first electrically conductive bumps can be absorbed and reduced.

Other objects and advantages of the present invention will be understood from the following description of burn-in sockets according to preferred embodiments of the present invention, which are shown in the accompanying drawings.

### Brief Description of the Drawings:

FIG. **1a** is an exploded view of a burn-in socket according to the present invention, and FIGS. **1b** and **1c** are sectional views of the burn-in socket;
FIG. **2** is a perspective view of the carrier of the burn-in socket;
FIG. **3** is a sectional view of the carrier of the burn-in socket;
FIG. **4** is a perspective view of the flexible circuit member of the burn-in socket;
FIG. **5** is a sectional view of the flexible circuit member;
FIG. **6** is a sectional view of a burn-in socket according to a first embodiment of the present invention;
FIG. **7** is a sectional view of a burn-in socket according to a second embodiment of the present invention; and
FIG. **8** is a sectional view of a burn-in socket according to a third embodiment of the present invention.

### Detailed Description of the Preferred Embodiments

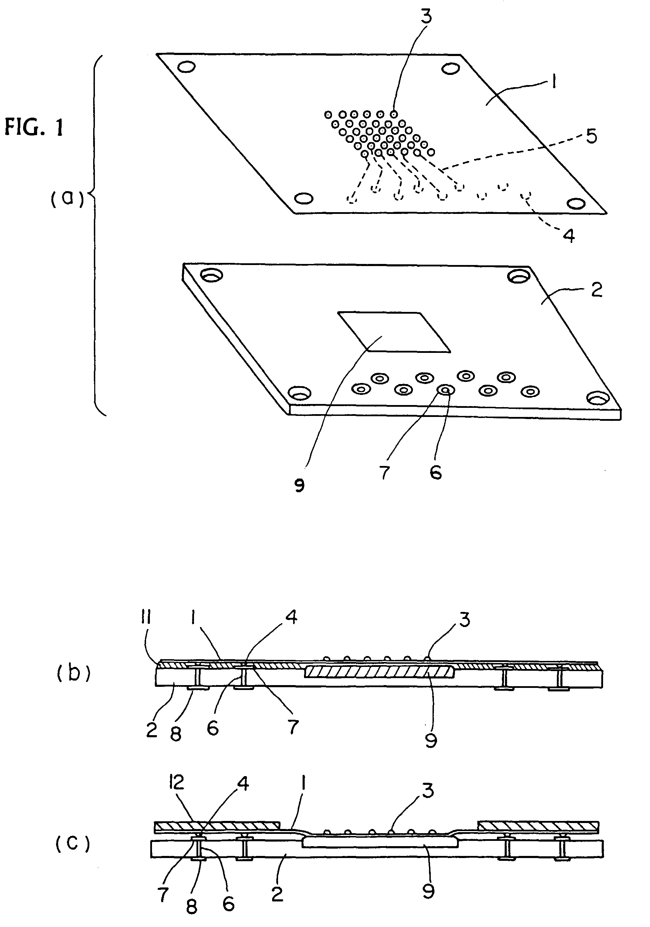

Referring to FIG. **1a**, a burn-in socket according to the present invention uses a flexible circuit member **1** and a carrier **2** of approximately the same size. The shape and size of the flexible circuit member and carrier will be dictated by the particular application, but preferably the flexible circuit member and carrier are both square and of the same size. The flexible circuit member **1** has first electrically conductive bumps **3** formed on its first side to abut on the exterior terminals of, for example, the chip scale area (CSA) of a semiconductor component such as a semiconductor bare chip or package to be put thereon (not shown), and second electrically conductive bumps **4** on the second side of the flexible circuit member **1**, the second electrically conductive bumps being positioned laterally relative to said first electrically conductive bumps. Preferably, the second electrically conductive bumps are formed on the circumferential edge space or margins of the second side of the flexible circuit member **1**. These first and second electrically conductive bumps **3** and **4** can be arranged in the form of ball grid array (BGA), and these first and second bumps **3** and **4** are electrically connected to each other in one-to-one correspondence via conductor patterns or circuits **5** formed in the flexible circuit member.

The conductor patterns or circuits **5** are formed by, for example, using photolithography, and can be given in the opposite sides of the flexible circuit member **1** or in the form of a multi-layer circuit when occasions demand. Such a multi-layer circuit may include a grounding plane to provide an impedance matching relative to the semiconductor component to be mounted.

The first and second electrically conductive bumps **3** and **4** can be formed, for example, by using an appropriate plating process such as electrolysis plating or electroless plating. Each bump may range from 0.01 to 1 millimeters long in diameter, and from 0.01 to 1 millimeters high. The electrically conductive bumps may be made of, for example, gold, silver, nickel, palladium, copper, chromium, platinum, rhodium, or other appropriate metal, as is well known in the art. Preferably, the bumps formed by plating are coated with gold, platinum, palladium or rhodium.

The carrier may be made of plastic, glass, epoxy resin, ceramic material, or other suitable insulating material. Preferably, the carrier is a substrate made of glass, epoxy resin or ceramic material. The carrier has conductive through holes **6** made in one-to-one correspondence in position relative to the second electrically conductive bumps **4**, each conductive through hole having electrically conductive contacts **7** and **8** thereupon on the upper and lower surfaces of the carrier **2** (FIG. **1b**). Each conductive contact is coated with, for example, gold, platinum, palladium, rhodium or any other noble metal, as is well known in the art, as is the case with the first and second electrically conductive bumps **3** and **4**. Preferably a resilient layer **9** of, for example, silicone resin, is provided at the center of the carrier **2** to confront the center area of the flexible circuit member **1** in which the first electrically conductive bumps **3** are formed.

Referring to FIG. **1b** or **1c**, the flexible circuit member **1** is laid on the carrier **2** to provide a burn-in socket **10**. In FIG. **1b** an organic adhesive agent **11** is applied to the carrier **2**, and the flexible circuit member **1** is put on the carrier **2**. The electrically conductive contacts **7** of the carrier **2** are coated with soldering material. When putting the flexible circuit member **1** on the carrier **2**, metal-to-alloy joining is made by soldering the electrically conductive contacts **7** of the carrier **2** to the second electrically conductive bumps **4** of the flexible circuit member **1**. In FIG. **1c** a resilient resin sheet **12** is laid on the flexible circuit member **1** to push the second electrically conductive bumps **4** of the flexible circuit member **1** against the electrically conductive contacts **7** of the carrier **2** by placing and pushing a cover plate (not shown) against the flexible circuit member - carrier assembly.

As for the electrically conductive contacts **8** formed on the lower surface of the carrier **2**, metal balls may be soldered to these electrically conductive contacts **8** to provide a ball grid array (BGA), or alternatively, metal pins may be soldered to the electrically conductive contacts **8** to provide a pin grid array (PGA), thereby permitting the mounting of the burn-in socket to a burn-in board.

In use, a semiconductor component such as a semiconductor package or semiconductor bare chip is put on the center area of the flexible circuit member **1** in which the first electrically conductive bumps **3** are formed, and then the cover plate is applied on this assembly to make the exterior terminals of the semiconductor package or semiconductor bare chip abut the first electrically conductive bumps **3**. The burn-in socket having the semiconductor component thereon is then placed on a burn-in board for burn-in testing. The structure of the second electrically conductive bumps **4**, formed and positioned in the flexible circuit member **1** laterally relative to the first electrically conductive bumps **3** of the flexible circuit member **1**, and electrically connected to the electrically conductive contacts **7** of carrier **2**, obviates the need for conductor pads from the periphery of the insulating film and metal spring contacts from the socket, thereby significantly reducing the size of the burn-in socket **10**. This down-sizing of burn-in sockets by virtue of the present invention therefore contributes to the increase of the number of burn-in sockets **10** that may be mounted in a burn-in board, and accordingly leads to the reduction of burn-in testing costs.

Electric connection between the second electrically conductive bumps **4** of the flexible circuit member **1** and the electrically conductive contacts **7** of the carrier **2** is made by adhering the flexible circuit member **1** onto the carrier **2** by an organic adhesive agent **11**, or alternatively by resiliently pushing the flexible circuit member **1** against the carrier **2** by using the resilient resin sheet **12** and the cover plate, as described above. The so made electric connection is quite reliable, and the reliability can be enhanced by making metal-to-alloy joinings between the second electrically conductive bumps **4** and the electrically conductive contacts **7** of the carrier **2**. The use of resilient resin sheet **12** permits easy interchanging of the flexible circuit member **1**.

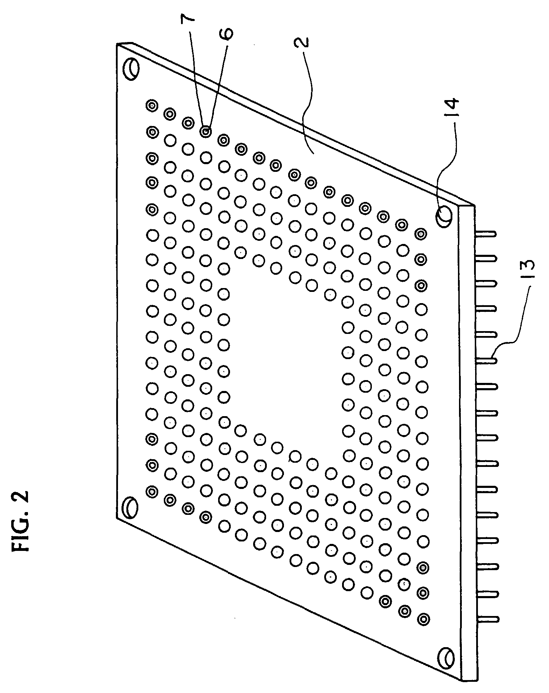

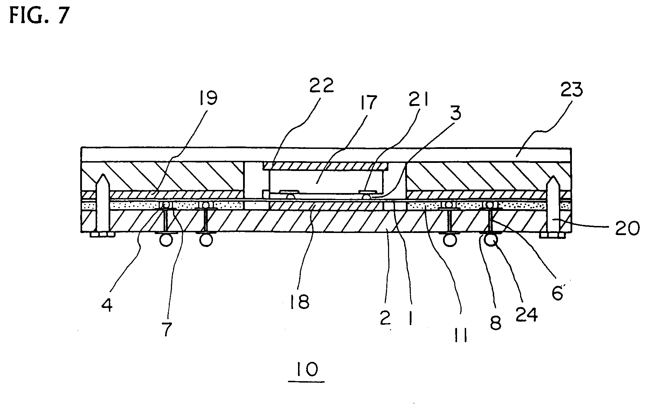

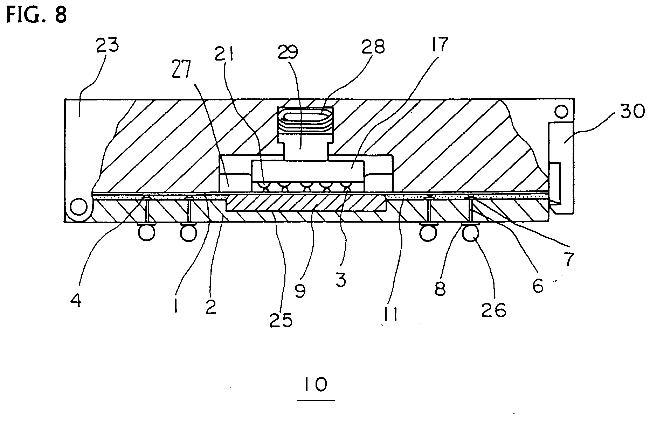

Referring now to FIGS. **1** and **2**, the carrier **2** has metal pins **13** or metal balls **24**, **26** (shown in FIGS. **7** and **8**) fixed to the electrically conductive contacts **8** on the rear side of the carrier **2**, and the carrier **2** can be mounted to a burn-in board by making use of such metal pins **13** or metal balls **24**, **26**, which attain required electric connections. For example, the burn-in board can use an ordinary pin grid array socket to mate with the grid array of the metal pins **13** of the burn-in socket, thus facilitating the mounting of the burn-in socket to the burn-in board. In mounting to a burn-in board a burn-in socket whose carrier **2** has metal balls **24**, **26** it is necessary to form the electrically conductive contacts in the burn-in board so as to be in conformity with the grid array of metal balls **24**, **26** of the carrier **2**, thereby making a required electric connection between the burn-in socket and the burn-in board by making the metal balls **24**, **26** to abut on the electrically conductive contacts **7**. Advantageously the burn-in socket **10** can be easily mounted to the burn-in board whether the burn-in socket **10** may have metal pins **13** or metal balls **24**, **26**. No matter how many external terminals a semiconductor component may have, the down-sizing of the burn-in socket can be attained by virtue of the present invention.

As shown in FIG. **8**, in a preferred embodiment the carrier **2** has a resilient resin layer **9** at its center area, and a spring member **28** is between the cover plate **23** and the semiconductor package or chip **17** to push the semiconductor package or chip against the flexible circuit member **1**, thus making the exterior terminals **21** of the semiconductor package or chip to contact the electrically conductive bumps **3** under a predetermined pressure. The spring factors can be determined in terms of the number of external terminals and required pressure strength. Irregularities, if any, on either side of the semiconductor package **17** or the electrically conductive bumps **3** can be absorbed and reduced by the resilient resin layer **9**.

### EXAMPLES

### Example 1.

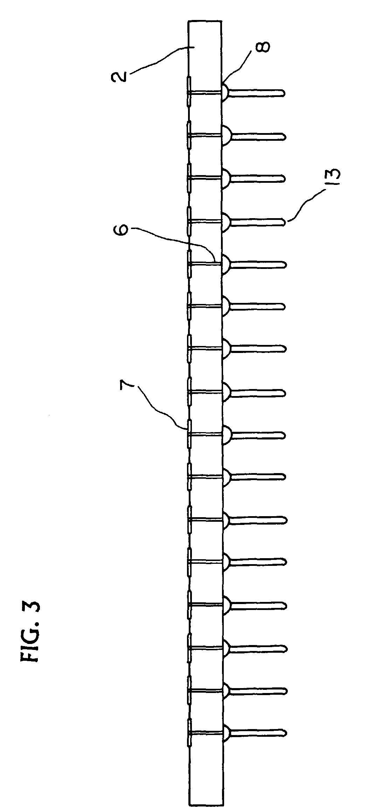

Referring to FIGS. **2** and **3**, a carrier **2** was a substrate of 0.5 mm thick alumina ceramic sheet of 30 mm x 30 mm, with electrically conductive through holes **6** made in its outermost circumference to be in conformity with a PGA socket commercially available. Each electrically conductive through hole **6** had an electrically conductive land **7** of 1 millimeter diameter formed by plating the through hole **6** with gold on the front side of the substrate **2**. Likewise, it had an electrically conductive land **8** of 1 millimeter diameter formed by plating the through hole **6** with gold on the rear side of the substrate **2**, and a metal pin **13** was gold-tin soldered to the electrically conductive land **8**. The carrier **2** had apertures **14** made at its corners for registration.

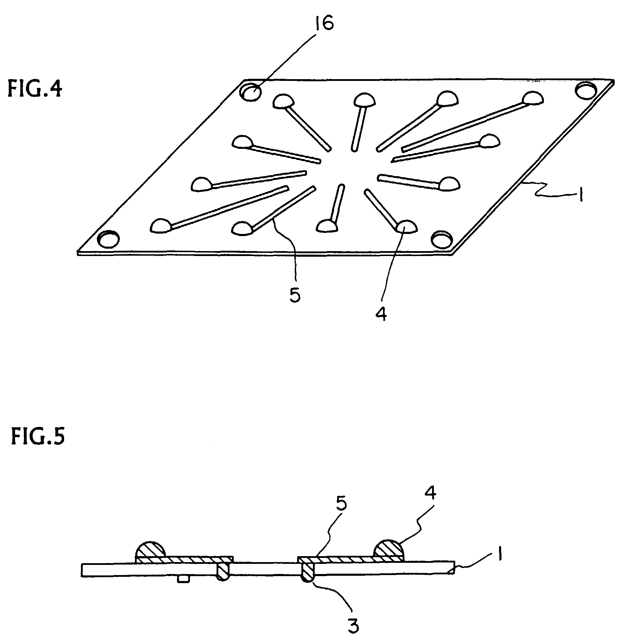

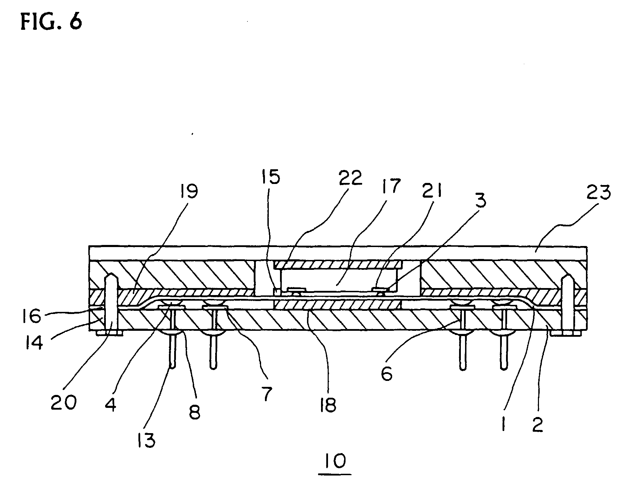

Referring to FIGS. **4** and **5**, a flexible circuit member **1** was an insulating film of 50 micron-thick polyimide film. First electrically conductive bumps **3**, which were 50 microns in diameter and 20 microns high, were formed at the center of the film **1** by gold plating such that these bumps **3** were positioned in one-to-one correspondence relative to the external terminals of a semiconductor package. On the opposite surface of the insulating film **1** a conductor pattern or circuit **5** was formed in a fan-out fashion to be connected to the first electrically conductive bumps **3**, ending with second electrically conductive bumps **4**, which were formed in the outer circumference of the film **1** to be positioned in one-to-one correspondence relative to the electrically conductive lands **7**. The second electrically conductive bump **4** was 300 microns in diameter and 50 microns high, and was coated with gold. The insulating film **1** had a stopper **15** formed outside of the bumps **3** by photolithography for the purpose of permitting registration of the insulating film **1** relative to a semiconductor package (see FIG. **6**) and the insulating film **1** had apertures **14** made at its corners for registration relative to the carrier **2**.

Referring to FIG. **6**, the insulating film-and-carrier assembly make up a burn-in socket **10**, and a semiconductor package **17** was set on the burn-in socket **10**. A 10 mm x 10 mm, 0.2 millimeter-thick silicone resin sheet **18** was laid on the center of the carrier **2**, and the insulating film **1** was laid thereon, and a 0.5 millimeter-thick silicone resin sheet **19** was laid on the insulating film **1**. Screws **20** were inserted in the registration apertures **14** and **16** of the insulating film-and-carrier assembly. A semiconductor package **17** was set on the center of the insulating film **1** with its external terminals **21** confronting the first electrically conductive bumps **3** by using the registration stopper **15** as reference. Another silicone resin sheet **22** was laid thereon, and finally a cover plate **23** was put on the laminated assembly. The cover plate **23** was tightened to the underlying lamination with screws to push the external terminals **21** of the semiconductor package **17** against the first electrically conductive bumps **3**, and at the same time, the second electrically conductive bumps **4** against the electrically conductive lands **7**.

A burn-in board (not shown) had an ordinary PGA socket soldered thereto, and the burn-in socket was mounted to the burn-in board by inserting the metal pins **13** of the carrier **2** into the counter holes of the PGA socket of the burn-in board. Thus, the semiconductor package was subjected to the burn-in test.

### Example 2.

Referring to FIG. **7**, a carrier **2** used was similar to the substrate of Example 1. The upper electrically conductive lands **7** of the electrically conductive through holes **6** were coated with soldering material, and gold-plated copper balls **24** of 0.7 millimeters in diameter were soldered to the lower electrically conductive lands **8** with gold-and-tin alloy.

An insulating film **1** used was similar to the film of Example 1. First electrically conductive bumps **3** were 50 microns in diameter and 20 microns high, and were plated with gold. The second electrically conductive bumps **4** were 0.5 mm long in diameter and 0.3 mm high, and were plated with gold.

In FIG. **6** the burn-in socket **10** of Example 2 had a semiconductor package **17** set thereon. The insulating film **1** was adhered to the carrier **2** by using an inorganic adhesive agent **11**, and the solder plated conductor lands **7** and the gold-plated second electrically conductive bumps **4** were heated to effect required metal-to-alloy joining, and a semiconductor package **17** was set on the burn-in socket **10**. A silicone resin sheet **18** was laid on the center of the carrier **2** as in Example 1, and another silicone resin sheet **19** was laid on the insulating film **1**. A semiconductor package **17** was set on the center of the insulating film **1**, and still another silicone resin sheet **22** was laid on the semiconductor package **17**. Finally, a cover plate **23** was put on the laminated structure, and was fixed by tightening associated screws **20**.

A burn-in board had conductor lands to be in conformity with the gold-plated copper balls **24** of the substrate **2**, and the burn-in socket **10** was mounted to the burn-in board by soldering the gold-plated copper balls **24** to the conductor lands **7**. Thus, the semiconductor package was subjected to the burn-in test.

### Example 3.

A carrier **2** used was a substrate of 1.5 millimeter-thick glass epoxy sheet of 30 mm x 30 mm, and a 0.5 millimeter-deep recess 25 of 10 mm x 10 mm was made at the center of the substrate. A silicone resin sheet was adhered in the recess **25** to provide a resilient resin layer **9**. Conductive through holes **6** were made in the outer circumference of the carrier **2**. Gold-plated conductor lands of 1 millimeter in diameter were formed around the conductive through holes **6** on the upper side of the carrier **2**, and the so formed conductor lands **7** were plated with soldering material. Similar conductor lands **8** were formed around the conductive through holes **6** on the lower side of the carrier **2**, and gold-plated copper balls **26** of 0.7 mm in diameter were soldered to the conductor lands **8**.

An insulating film **1** was a 50 micron-thick polyimide film, which was similar to Examples 1 and 2. First gold-plated electrically conductive bumps **3** of 200 micron-large diameter and 60 micron-high were formed on the upper surface of the film **1** whereas second gold-plated electrically conductive bumps **4** of 500 micron-large diameter and 50 micron-height were formed on the lower surface of the film **1**, and a conductor pattern or circuit **5** was formed to connect the first and second bumps **3** and **4** together.

The carrier **2** and the insulating film **1** were integrated by using an organic adhesive agent **11**, and by heating and making the metal-to-alloy joining of the solder-plated conductor lands **7** and the second bumps **4**.

Referring to FIG. **8**, the burn-in socket **10** had a semiconductor package **17** set thereon. The semiconductor package **17** was put in correct position with the aid of an associated frame **27** so that the external terminals **21** of the semiconductor package **17** abutted on the first electrically conductive bumps **3** of the insulating film **1** in one-to-one correspondence, and the cover plate **23** was used to hold compress them in tight condition. The cover plate **23** had a coiled spring **28** and a pusher **29** at its center, thereby permitting the pusher **29** to push the semiconductor package **17** against the insulating film **1** under a predetermined pressure. The cover plate **23** was fixed to the carrier **2** by using fasteners **30**.

A burn-in board had conductor lands to be in conformity with the gold-plated copper balls **26** of the carrier **2**, and the burn-in socket **10** was mounted to the burn-in board by soldering the gold-plated copper balls **26** to the conductor lands. Thus, the semiconductor package was subjected to the burn-in test.

The Examples are described as being used for testing semiconductor packages **17**. As a matter of course, they can be equally used for testing other semiconductor components such as semiconductor bare chips.

It will be understood that the invention may be embodied in other specific forms without departing from the spirit or central characteristics thereof. The present examples and embodiments, therefore, are to be considered in all respects as illustrative and not restrictive, and the invention is not to be limited to the details given herein.

## Claims

1. A device for burn-in testing of a semiconductor component comprising:
a carrier having electrically conductive contacts;
a flexible circuit member with a first side and a second side, said flexible circuit member having a conductor pattern;
first electrically conductive bumps formed on the first side of said flexible circuit member, said first electrically conductive bumps being connected to said conductor pattern and adapted to abut one or more exterior terminals of the semiconductor component; and
second electrically conductive bumps formed on the second side of said flexible circuit member, said second electrically conductive bumps being connected to said first electrically conductive bumps via said conductor pattern, said second electrically conductive bumps being positioned laterally relative to said first electrically conductive bumps and being arranged in said flexible circuit member relative to said electrically conductive contacts in a one-to-one correspondence in position, thereby permitting said second electrically conductive bumps to form an electrical connection with said electrically conductive contacts when said flexible circuit member is laid on said carrier.

2. The device according to claim 1 wherein electric connection between said second electrically conductive bumps and said electrically conductive contacts of said carrier is made by adhering said flexible circuit member onto said carrier by an organic adhesive agent.

3. The device according to claim 1 wherein electric connection between said second electrically conductive bumps and said electrically conductive contacts of said carrier is made by forming metal-to-alloy joinings between said second electrically conductive bumps and said electrically conductive contacts of said carrier.

4. The device according to claim 1 wherein electric connection between said second electrically conductive bumps of said flexible circuit member and said electrically conductive contacts of said carrier is made with a resilient pushing force, which is produced by a resilient resin sheet laid on said carrier.

5. The device according to claim 1 further comprising a resilient resin sheet laid on said carrier.

6. The device according to claim 5 wherein said resilient resin sheet comprises silicone resin.

7. The device according to claim 1 wherein said carrier has metal balls formed on the side opposite to the side on which the electrically conductive contacts are formed, said metal balls being connected to said electrically conductive contacts via electrically conductive through holes.

8. The device according to claim 1 wherein said carrier has metal pins standing upright on the side opposite to the side on which said electrically conductive contacts are formed, said metal pins being connected to the electrically conductive contacts of the carrier via electrically conductive through holes.

9. The device according to claim 1 wherein said flexible circuit member has a resilient resin layer on the side opposite to the side on which said first electrically conductive bumps are formed, the device further comprising a spring member to push the semiconductor against said first electrically conductive bumps.

10. The device according to claim 1 wherein said carrier is a substrate.

11. The device according to claim 10 wherein said substrate comprises an alumina ceramic sheet.

12. The device according to claim 10 wherein said substrate comprises a glass epoxy sheet.

13. The device according to claim 1 wherein said flexible circuit member comprises an insulating film.

14. The device according to claim 13 wherein said insulating film comprises a polyimide film.

15. A device for burn-in testing of a semiconductor component comprising:
a substrate having electrically conductive through holes;
first and second electrically conductive lands formed within said electrically conductive through holes;
a metal member gold-tin soldered to said second electrically conductive land;
an insulating film with a first side and a second side, said insulating film having a conductor pattern formed in a fan-out fashion;
first electrically conductive bumps formed on the first side of said insulating film, said first electrically conductive bumps being connected to said conductor pattern and adapted to abut one or more exterior terminals of a semiconductor component; and
second electrically conductive bumps formed on the second side of said insulating film, said second electrically conductive bumps being connected to said first electrically conductive bumps via said conductor pattern, said second electrically conductive bumps being formed in an outer circumference of said insulating film and being arranged in said insulating film relative to said first electrically conductive lands in a one-to-one correspondence in position, thereby permitting said second electrically conductive bumps to form an electrical connection with said first electrically conductive lands when said insulating film is laid on said substrate.

16. The device of claim 15 further comprising:
a first silicone resin sheet interposed between said substrate and said insulating film;
a second silicon resin sheet interposed between said insulating film and the semiconductor component; and
a third silicone resin sheet interposed between the semiconductor component and a cover plate.

17. The device of claim 15 wherein said insulating film is adhered to said substrate by using an organic adhesive agent, and wherein said first electrically conductive lands and said second electrically conductive bumps are heated to effect a metal-to-alloy junction.

18. The device of claim 15 wherein said cover plate comprises a coiled spring and a pusher.

19. The device of claim 15 wherein said metal member comprises a metal ball.

20. The device of claim 15 wherein said metal member comprises a metal pin.

21. A device for burn-in testing of a semiconductor component comprising:
a flexible circuit member with a first side and a second side, said flexible circuit member having a conductor pattern;
first electrically conductive bumps formed on the first side of said flexible circuit member, said first electrically conductive bumps being connected to said conductor pattern and adapted to abut one or more exterior terminals of the semiconductor component; and
second electrically conductive bumps formed on the second side of said flexible circuit member, said second electrically conductive bumps being connected to said first electrically conductive bumps via said conductor pattern, said second electrically conductive bumps being positioned laterally relative to said first electrically conductive bumps and being arranged in said flexible circuit member relative to said electrically conductive contacts in a one-to-one correspondence in position.
